(19) Europäisches Patentamt
European Patent Office
Office européen des brevets

(11) **EP 2 110 458 B1**

(12) **FASCICULE DE BREVET EUROPEEN**

(45) Date de publication et mention
de la délivrance du brevet:
**08.12.2010 Bulletin 2010/49**

(51) Int Cl.:
**C23C 16/04** *(2006.01)*

(21) Numéro de dépôt: **09158141.3**

(22) Date de dépôt: **17.04.2009**

(54) **Four de traitement thermique avec chauffage inductif**

Wärmebehandlungsofen mit Induktionsheizung

Thermal treatment furnace with induction heating

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **18.04.2008 FR 0852641**

(43) Date de publication de la demande:
**21.10.2009 Bulletin 2009/43**

(73) Titulaire: **Messier-Bugatti**
**78140 Velizy Villacoublay (FR)**

(72) Inventeurs:
• **Delperier, Bernard**
**33700, Merignac (FR)**
• **Baudry, Yvan**
**33000, Bordeaux (FR)**
• **Petitjean, Olivier**
**69440, Saint Laurent d'Agny (FR)**

(74) Mandataire: **Joly, Jean-Jacques et al**
**Cabinet Beau de Loménie**
**158, rue de l'Université**
**75340 Paris cedex 07 (FR)**

(56) Documents cités:
**US-B1- 6 572 371**

**Description**

Arrière-plan de l'invention

L'invention concerne les installations ou fours à chauffage inductif utilisés pour réaliser des traitements thermiques et dans lesquels le ou les gaz utilisés dans les traitements sont préchauffés avant leur introduction dans la chambre de traitement du four. De tels fours sont notamment utilisés pour réaliser des traitements thermochimiques comme la cémentation de pièces ou la densification de substrats poreux par infiltration chimique en phase gazeuse.

Un domaine d'application de l'invention est celui de la réalisation de pièces en matériau composite thermostructural, c'est-à-dire en matériau composite ayant à la fois des propriétés mécaniques qui le rendent apte à constituer des pièces structurelles et la capacité de conserver ces propriétés jusqu'à des températures élevées. Des exemples typiques de matériaux composites thermostructuraux sont les composites carbone/carbone (C/C) ayant une texture de renfort en fibres de carbone densifiée par une matrice de carbone pyrolytique et les composites à matrice céramique (CMC) ayant une texture de renfort en fibres réfractaires (carbone ou céramique) densifiée par une matrice céramique.

US 6.572.371 A1 décrit un processus bien connu de densification de substrats poreux pour réaliser des pièces en composite C/C ou en CMC est l'infiltration chimique en phase gazeuse (CVI). Les substrats à densifier sont placés dans une zone de chargement d'un four où ils sont chauffés. Un gaz réactif contenant un ou plusieurs précurseurs gazeux du matériau constitutif de la matrice est introduit dans le four. La température et la pression dans le four sont réglées pour permettre au gaz réactif de diffuser au sein de la porosité des substrats et y former un dépôt du matériau constitutif de la matrice par décomposition d'un ou plusieurs constituants du gaz réactif ou réaction entre plusieurs constituants, ces constituants formant le précurseur de la matrice. Le processus est réalisé sous pression réduite, afin de favoriser la diffusion des gaz réactifs dans les substrats. La température de transformation du ou des précurseurs pour former le matériau de la matrice, tel que carbone pyrolytique ou céramique, est dans la plupart des cas supérieure à 900° C, typiquement voisine de 1000° C.

Afin de réaliser une densification la plus homogène possible des substrats dans toute la zone de chargement du four, que ce soit en terme d'accroissement de densité ou en terme de microstructure du matériau de matrice formé, il est nécessaire que la température dans toute la zone de chargement soit sensiblement uniforme.

Aussi, les fours comportent habituellement une zone ou chambre de préchauffage de gaz réactif située entre l'entrée du gaz réactif dans le four et la zone de chargement. Typiquement, la zone de préchauffage comprend une pluralité de plateaux perforés parcourus par le gaz réactif.

Les plateaux de préchauffage du gaz, de même que les substrats sont chauffés du fait de leur présence dans le four. Le chauffage de ce dernier est généralement assuré au moyen d'un induit, encore appelé suscepteur, par exemple en graphite, qui définit la paroi latérale du four et est couplé à un inducteur entourant le four. Selon le principe bien connu du chauffage par induction, lorsque le suscepteur est placé dans un champ magnétique variable généré par la circulation d'un courant dans l'inducteur, un courant induit, "reflétant" le courant inducteur, circule dans le suscepteur. Le courant induit circulant dans le suscepteur provoque l'échauffement de ce dernier par effet Joule. La chaleur ainsi dissipée est transmise par rayonnement dans l'enceinte du four délimitée par le suscepteur.

Dans le cas de fours de grandes dimensions (grands diamètres), la déposante a observé qu'il existe des inhomogénéités de température. Un exemple significatif est celui de la densification de substrats par infiltration chimique en phase gazeuse isotherme (ICVI), lesdits substrats étant constitués par des préformes annulaires en fibres de carbone, ou des ébauches annulaires prédensifiées, pour la réalisation de disques de frein en composite C/C. Les substrats sont disposés en une ou plusieurs piles verticales dans la zone de chargement, au-dessus de la chambre de préchauffage du gaz réactif située à la partie inférieure du four. Il est important de minimiser les variations de température du gaz réactif tout au long du processus de densification pour réduire les inhomogénéités de densification dans les piles. Or, avec une chambre de préchauffage telle que décrite précédemment, on a observé des variations de température.

D'une manière générale, pour n'importe quel four de traitement thermique comprenant une chambre de préchauffage de gaz, il est souhaitable que le préchauffage du gaz assure une meilleure maîtrise thermique tout au long de la densification.

Afin de résoudre ce problème, il pourrait être envisagé d'accroître l'efficacité du préchauffage du gaz par agrandissement de la zone de chauffage notamment par augmentation de son volume en hauteur au détriment de celui de la zone chargement à volume total de four égal. Or, les traitements tels que les processus d'infiltration chimique en phase gazeuse demandent des investissements coûteux à l'échelle industrielle, et sont très longs à réaliser. Il est donc hautement souhaitable que les fours aient une productivité élevée, que ce soient des fours en service ou de nouveaux fours à réaliser, donc un rapport aussi élevé que possible entre volume utile dédié au chargement des substrats ou pièces à traiter et volume dédié au chauffage du gaz réactif.

**EP 2 110 458 B1**

Objet et résumé de l'invention

L'invention a pour but de proposer une conception de four de traitement thermique qui permet d'accroître l'efficacité du préchauffage, et ce sans requérir un volume important de la zone de chauffage du gaz, donc sans affecter, et voire même en améliorant la productivité des fours.

A cet effet, la présente invention propose un four de traitement thermique, comprenant une zone de chargement ou de traitement, au moins une entrée de gaz, une chambre de préchauffage de gaz située dans le four entre l'entrée du gaz et la zone de chargement ou de traitement, un suscepteur comprenant au moins une paroi latérale entourant la chambre de préchauffage et la zone de chargement ou de traitement, et un inducteur apte à chauffer la paroi latérale par induction, four dans lequel, conformément à l'invention, la partie de la paroi latérale du suscepteur située autour la chambre de préchauffage présente au moins deux évidements espacés circonférentiellement les uns des autres de manière à former des portions d'épaisseur réduite sur ladite partie de paroi latérale.

En utilisant un suscepteur dont la paroi latérale autour de la chambre de préchauffage présente au niveau des évidements des portions d'épaisseur réduite, on crée des zones de d'échauffement localisées (pics de températures ponctuels).

Grâce à ces échauffements localisés, on augmente en outre la température globale dans la chambre de préchauffage. On améliore ainsi l'efficacité de la chambre de préchauffage sans avoir à recourir à une augmentation de son volume préjudiciable à la capacité de chargement du four.

Comme cela sera montré plus loin, on peut assurer aussi une meilleure maîtrise thermique en réduisant les variations de la température à laquelle les substrats sont exposés tout au long de la densification.

Conformément à l'invention, la partie du suscepteur comprenant les évidements est située au niveau de la chambre de préchauffage pour éviter de créer des points chauds dans la zone de chargement qui conduiraient, dans le cas d'un traitement thermique appliqué à la densification de substrats poreux, à une densification accélérée des substrats voisins de ces points par rapport aux autres substrats plus éloignés.

Les évidements peuvent être ménagés sur la périphérie interne ou sur la périphérie externe de la paroi latérale du suscepteur. Les évidements s'ouvrent de préférence vers l'extérieur de la virole. Les évidements sont de préférence régulièrement espacés les uns des autres de manière à avoir une bonne répartition de la chaleur émise depuis les portions à épaisseur réduite. Dans le cas par exemple où la partie de la paroi latérale du suscepteur comporte trois évidements, ceux-ci sont espacés de 120° les uns des autres. Les évidements peuvent être en outre remplis avec un matériau électriquement et thermiquement isolant tel que de l'alumine.

La hauteur des évidements est de préférence inférieure à celle de la chambre de préchauffage et du support de la charge afin de localiser les portions d'épaisseur réduite au niveau de la chambre de préchauffage et d'éviter ainsi la génération de points chauds dans la zone de chargement qui pourraient perturber localement la cinétique de dépôt dans les substrats.

Selon un aspect de l'invention, la paroi latérale du suscepteur est segmentée en au moins deux viroles: une virole inférieure comportant les évidements et une virole supérieure entourant principalement la zone de chargement ou de traitement. La partie de la paroi latérale du suscepteur comportant les évidements peut être ainsi réalisée indépendamment du reste de la paroi.

Selon un autre aspect particulier de l'invention, la virole inférieure forme la paroi latérale de la chambre de préchauffage et comporte un épaulement pour supporter le plateau supérieur de la chambre de préchauffage.

Selon encore un autre aspect particulier de l'invention, la virole inférieure peut être découplée de la chambre de préchauffage.

L'inducteur est piloté par un générateur de tension alternative dont la fréquence est comprise entre 50 Hz et 1000 Hz environ.

Brève description des dessins

D'autres particularités et avantages du four de densification conforme à l'invention ressortiront à la lecture de la description faite ci-après, à titre indicatif mais non limitatif, en référence aux dessins annexés sur lesquels :

- la figure 1 est une vue schématique en coupe d'un mode de réalisation d'un four de densification conforme à l'invention;
- la figure 2 est une vue en coupe du four de la figure 1 selon le plan II-II;
- la figure 3 est une vue agrandie de la partie inférieure du four de la figure 1;
- la figure 4 est une vue en perspective de la virole inférieure du suscepteur du four de la figure 1;
- la figure 5 est une vue en perspective d'une variante de réalisation de la virole inférieure de la figure 4;
- la figure 6 est un graphique montrant l'évolution de la température respectivement au voisinage et à l'opposé d'un évidement de la virole inférieure du suscepteur;

3

- la figure 7 est une vue agrandie de la partie inférieure d'un autre mode de réalisation d'un four de densification conforme à l'invention; et
- la figure 8 est une vue en perspective de la virole inférieure du suscepteur du four de la figure 7.

Description détaillée de modes de réalisation

L'invention s'applique à tout type d'installations ou fours à chauffage inductif utilisés pour réaliser des traitements thermiques et dans lesquels le ou les gaz utilisés dans les traitements sont préchauffés dans une chambre de préchauffage avant leur introduction dans la zone de traitement ou de chargement du four. De tels fours sont notamment utilisés pour réaliser des traitements thermochimiques comme la cémentation de pièces ou la densification de substrats poreux par infiltration chimique en phase gazeuse.

Des modes de réalisation du four conforme à l'invention seront décrits ci-après dans le cadre de l'application à la densification de substrats poreux annulaires constitués par des préformes en fibres de carbone ou des ébauches prédensifiées destinées à la réalisation de disques de frein en matériau composite C/C. De tels disques sont couramment utilisés pour des roues d'avions et pour des automobiles de compétition.

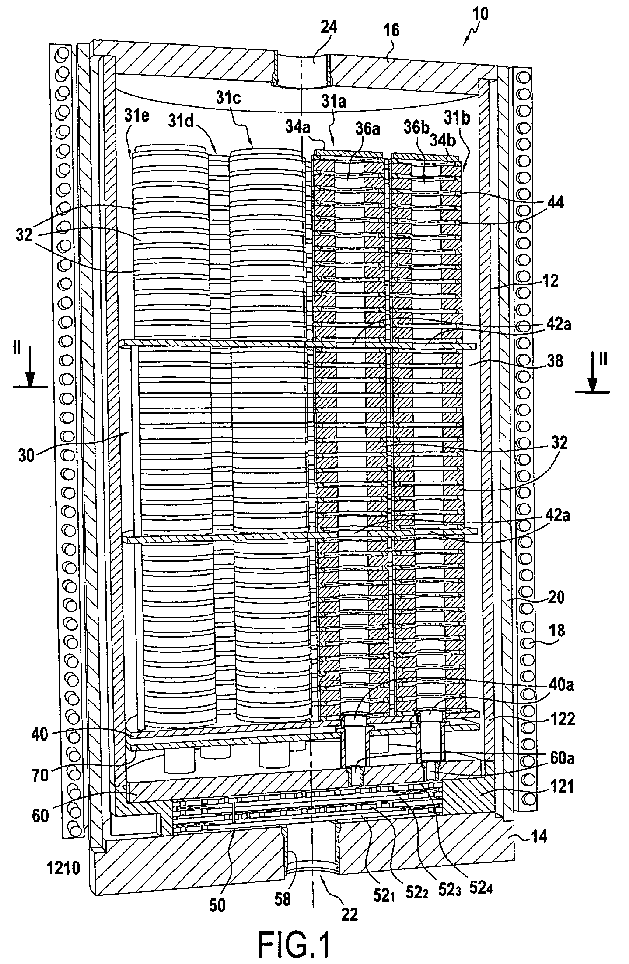

Un premier mode de réalisation d'un four de densification est décrit en relation avec les figures 1 à 3. La figure 1 montre schématiquement un four 10 délimité par une paroi latérale cylindrique 12, une paroi de fond 14 et une paroi supérieure 16.

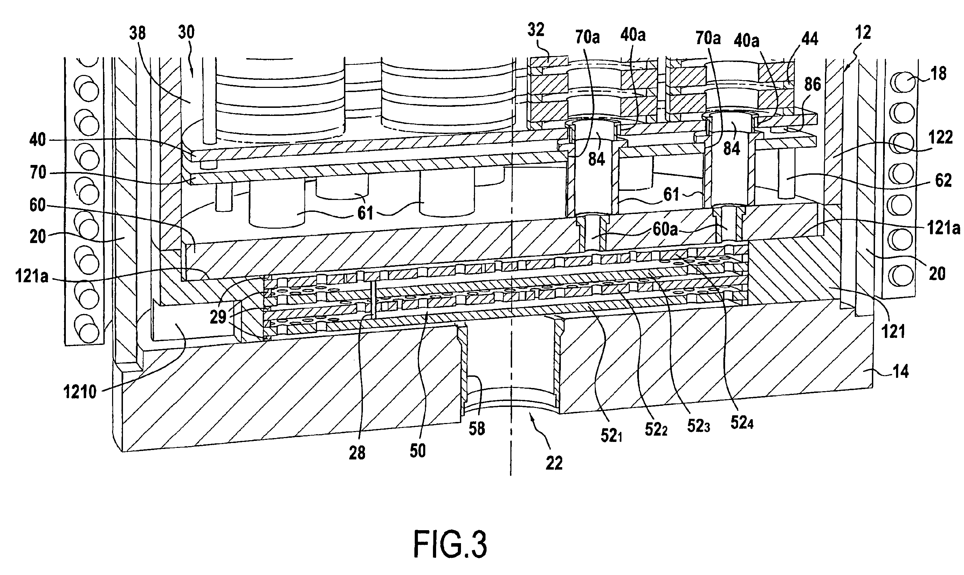

Une chambre de préchauffage de gaz 50 s'étend entre le fond 14 du four et un plateau de distribution de gaz 60. De façon bien connue, la chambre de préchauffage 50 comprend plusieurs plateaux perforés $52_1$ à $52_4$, par exemple en graphite, disposés les uns au-dessus des autres, et maintenues espacés les uns des autres par des colonnettes 28 et des entretoises annulaires 29 également réalisées par exemple en graphite (figure 3). Une conduite 58 relie l'entrée de gaz réactif 22 à la chambre de préchauffage 50, à travers le fond 14.

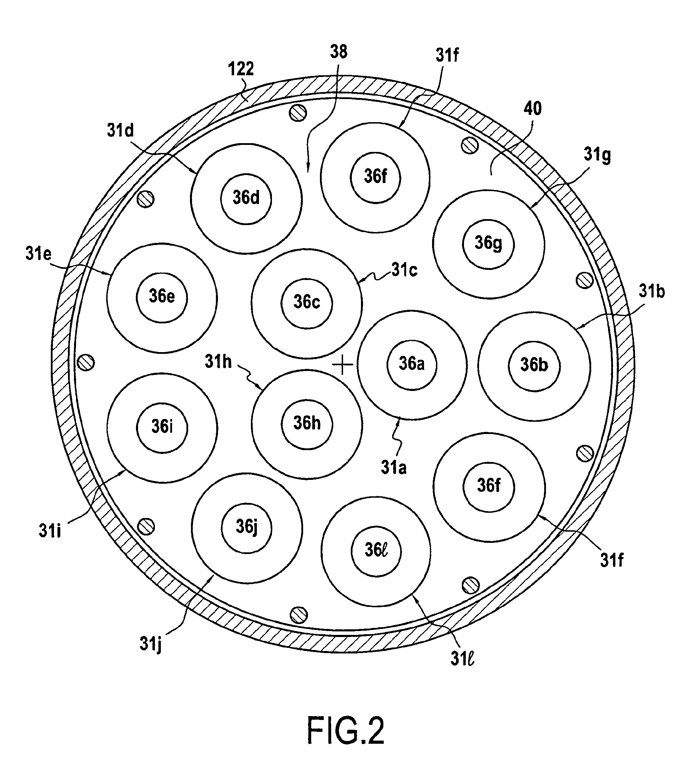

Les substrats à densifier 32 sont disposés dans une zone de chargement 30 (ou chambre de réaction) en une pluralité de piles verticales annulaires 31a à 31l (figure 2) qui reposent sur un plateau support de chargement 40. Celui-ci comprend une pluralité de passages 40a alignés avec les volumes internes 36a à 36l des piles et chaque pile est obturée à sa partie supérieure par un couvercle tel que 34a ou 34b. Le plateau de distribution de gaz comprend une pluralité de passages 60a alignés avec les passages 40a et les volumes internes 36a à 36l (figure 3). Les passages 60a sont reliés aux passages 40a par des conduits ou cheminées 61 débouchant dans des ouvertures 70a d'un plateau de maintien 70 alignées avec les ouvertures 40a. Des bagues 84 sont en outre disposées entre le sommet des cheminées 61 et les ouvertures 40a. Le plateau 70 supporte le plateau de chargement 40 avec des colonnes 86. De même, le plateau 70 est supporté par le plateau de distribution de gaz 60 au moyen de colonnes 62.

Les piles 31a à 31l de substrats reposent sur le plateau support de chargement 40 et peuvent être divisées en plusieurs sections superposées séparées par un ou plusieurs plateaux intermédiaires 42 ayant des passages centraux 42a alignés avec ceux des substrats 32. Chaque substrat 32 est séparé d'un substrat adjacent ou, le cas échéant, d'un plateau 40, 42 ou du couvercle 34 par des cales d'espacement 44 qui définissent des intervalles 46. Les cales 44, ou au moins une partie d'entre elles, sont aménagées pour ménager des passages pour le gaz entre les volumes 36a à 36l et 38. Ces passages peuvent être réalisés de manière à équilibrer sensiblement la pression entre les volumes 36 et 38, comme décrit dans le brevet US 5 904 957, ou de manière à constituer de simples passages de fuite maintenant un gradient de pression entre les volumes 36 et 38, comme décrit dans la demande de brevet déposée sous le numéro EP 0 063 988.

Le gaz réactif admis dans le four à travers l'entrée 22 traverse la chambre de préchauffage 50 en circulant à travers les multiples perforations des plateaux 52. Le gaz préchauffé est ensuite acheminé par les passages 60a et les cheminées 61 et parvient dans les volumes internes 36a à 36l des piles à travers les passages tels que 40a et 40b du plateau 40. Le gaz passe ensuite dans le volume 38 externe aux piles à l'intérieur de la zone de chargement 30. Le gaz effluent est extrait par un passage 24 formé dans la paroi supérieure 16, le passage 24 étant relié par une conduite 26 à des moyens d'aspiration, tels qu'une pompe à vide (non représentée).

Bien que douze piles soient représentées sur la figure 2, le nombre de piles pourra bien entendu être plus ou moins important.

Selon une variante de réalisation, les volumes internes 36a à 36l peuvent être fermés au niveau de leur partie inférieure et mis en communication à sa partie supérieure avec le passage 24. Le gaz réactif provenant de la chambre de préchauffage 50 est alors admis dans le volume 38 de la zone de chargement et la circulation du gaz dans cette zone se fait du volume 38 vers les volumes 36a à 36l, le volume 38 étant obturé à sa partie supérieure.

Selon encore une autre variante, l'entrée du gaz réactif peut être réalisée à travers la paroi supérieure 16 du four, la zone de chauffage étant alors située à la partie supérieure du four, les volumes 36a à 36l étant en communication avec la zone de chauffage et obturés à leur partie inférieure tandis que le volume 38 communique avec une sortie de gaz formée dans la paroi inférieure du four, ou inversement.

Pour la formation d'une matrice en carbone pyrolytique, le gaz réactif contient un ou plusieurs précurseurs du carbone tels que des hydrocarbures. L'infiltration chimique en phase gazeuse est réalisée à une température généralement supérieure à 900°C, par exemple comprise entre 950°C et 1100°C, et sous une pression réduite, par exemple inférieure à 0,1 kPa.

La paroi latérale cylindrique 12 constitue un induit, ou suscepteur, par exemple en graphite, qui est couplé avec un inducteur 18 situé à l'extérieur du four et formé d'au moins une bobine d'induction. Un isolant 20 est interposé entre l'inducteur 18 et la paroi 12. De façon bien connue, le chauffage du four est assuré par l'échauffement de l'induit 12 lorsque l'inducteur 18 est alimenté avec une tension alternative. A cet effet, la ou les bobines de l'inducteur sont reliées à un générateur de tension alternative (non représenté).

Le champ magnétique créé par l'inducteur 18 induit dans la paroi 12 (suscepteur) un courant électrique qui provoque par effet Joule l'échauffement de cette dernière. La température atteinte lors de la circulation du courant induit dépend alors directement de la section de passage disponible pour ce courant.

La puissance dissipée dans un conducteur peut être exprimée avec l'équation suivante:

$$P = R.I^2,$$

avec:

P = puissance dissipée,
R = valeur de résistance du conducteur
I = courant circulant dans le conducteur;

Par ailleurs, la résistance d'un conducteur se calcule suivant l'équation:

$$R = \rho.l/S$$

avec :

R = résistance en $\Omega$ (ohm)
$\rho$ = résistivité en $\mu\Omega.m$
l = longueur en mètres
S = section en millimètres carrés

Par conséquent, un rétrécissement de la section de passage du courant induit entraîne une augmentation de la puissance dissipée et donc de la température d'échauffement du conducteur.

La résistance, et, par conséquent, la puissance dissipée, peuvent être encore augmentées lorsque le rétrécissement de la paroi du suscepteur entraîne une augmentation de la taille de l'entrefer.

Conformément à l'invention, la partie de la paroi latérale 12 qui entoure la chambre de préchauffage 50 comporte des portions de section réduite afin de créer des points d'échauffement localisés à ce niveau du four.

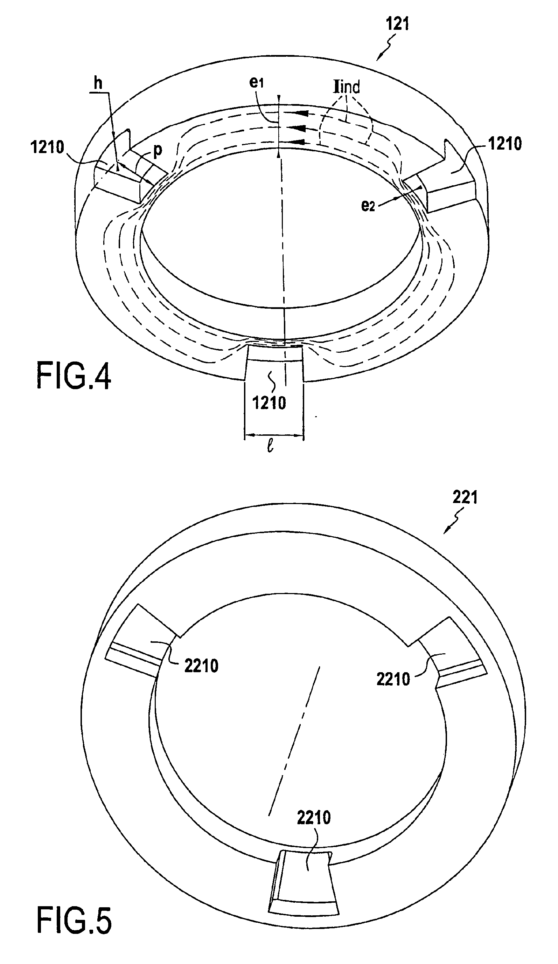

Plus précisément, comme représentée sur les figures 1 et 3, la paroi latérale 12 est formée au moins en deux parties, à savoir une virole supérieure 122 dont la paroi présente une épaisseur uniforme et une virole inférieure 121 qui comprend trois évidements 1210 répartis uniformément sur la périphérie externe de la virole 121. Comme illustré sur la figure 4, chaque évidement 1210 forme dans la virole inférieure 121 une portion de paroi qui présente une épaisseur $e_2$ inférieure à l'épaisseur $e_1$ du reste de la paroi de la virole.

Les évidements 1210 présentent une hauteur h qui est d'une manière générale au moins légèrement inférieure à la hauteur de la chambre de préchauffage pour ne pas créer de points chauds dans la zone de chargement nuisibles à l'uniformité de densification des substrats.

La profondeur p des évidements, qui détermine la réduction d'épaisseur de paroi désirée, est fonction de la température de l'échauffement localisé ("surchauffe") que l'on souhaite obtenir au niveau des portions d'épaisseur réduite. En effet, comme illustré sur la figure 4, le courant induit $I_{ind}$ qui circule dans la virole inférieure 121 du suscepteur dispose d'une section de passage plus réduite au niveau des évidements 1210 puisque la paroi de la virole inférieure 121 présente à ces endroits une épaisseur $e_2$ inférieure à l'épaisseur $e_1$ du reste de la paroi. La circulation du courant dans ces sections de passage plus réduites crée par effet Joule un échauffement plus important que dans les autres parties de la virole inférieure 121. Plus on réduit l'épaisseur $e_2$ (c'est-à-dire plus on augmente la profondeur p des évidements), plus on augmente l'effet d'échauffement localisé. Cependant, la réduction de l'épaisseur de la paroi au niveau des évidements 1210 est limitée à une épaisseur à partir de laquelle le matériau de la virole inférieure 121 devient trop fragile mécaniquement. L'épaisseur $e_2$ correspond de préférence entre 30% et 60% de l'épaisseur $e_1$ du reste de la paroi.

Les évidements 1210 présentent encore une largeur $l$ qui est déterminée en fonction de la longueur du passage de courant à section réduite (longueur de la zone d'échauffement localisé) que l'on souhaite obtenir. Toutefois, la largeur $l$ doit en outre être suffisamment grande pour éviter les risques de formations d'arcs électriques entre les bords latéraux des évidements 1210 qui annihileraient l'effet d'échauffement en permettant à une partie du courant induit de circuler en contournant la portion de section réduite. Les évidements 1210 peuvent présenter, par exemple, une largeur $l$ d'au moins 15 cm environ si elle est compatible avec la tension de claquage. La largeur minimum des évidements est déterminée en fonction de la pression du gaz utilisé dans le four. En effet, selon la loi de Paschen, plus la pression est basse, plus le risque d'apparition d'un arc électrique à une tension de claquage donnée est élevé. Les trois évidements 1210 occupent sensiblement entre 20% et 30% de la périphérie de la virole.

Dans ce mode de réalisation, la virole inférieure 121 présente sur sa périphérie interne un épaulement 121a (figure 3) qui forme une embase sur laquelle repose le plateau de distribution de gaz 60.

Des mesures de températures ont été réalisées pour montrer les effets produits lorsque la virole du suscepteur comporte des évidements conformément à la présente invention. Ces mesures ont été effectuées dans un four similaire à celui présenté précédemment en relation avec les figures 1 à 4, c'est-à-dire un four dont la virole inférieure du suscepteur comporte trois évidements répartis uniformément (à 120° les uns des autres) sur la périphérie externe de la virole inférieure. La virole inférieure du suscepteur présente un diamètre externe de 4190 mm et un diamètre interne de 3830 mm au dessus de l'épaulement et de 2980 mm en dessous de l'épaulement. Les trois évidements présente chacun une hauteur de 238 mm, une profondeur de 212 mm et une largeur de 200 mm.

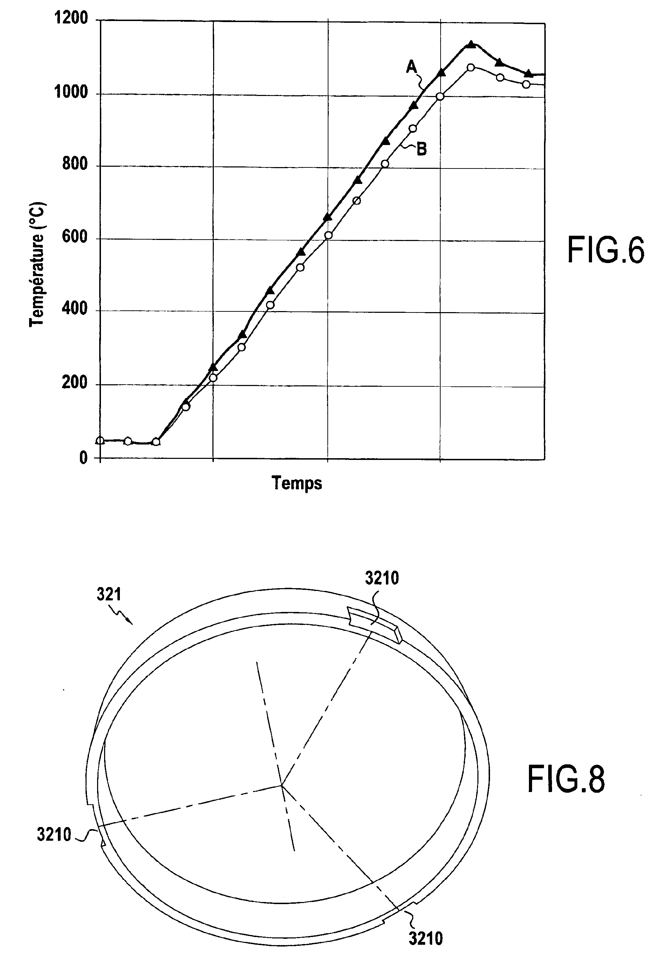

La figure 6 montre l'évolution de la température lors de la mise en chauffe du four. La courbe A représente la température mesurée avec une sonde de température située à 380 mm de la base du suscepteur au dessus d'un évidement tandis que la courbe B représente la température mesurée avec une sonde de température également située à 380 mm de la base du suscepteur mais dans une partie opposée à un évidement. On constate que la température lors de la mise en chauffe du four est plus importante au voisinage des évidements que dans les autres portions de la virole. Cela démontre la capacité des évidements à créer des zones d'échauffement localisées sous l'effet de l'induction.

Le tableau ci-dessous montre les températures relevées lors d'un cycle d'infiltration CVI à la fois dans un four de l'art antérieur, c'est-à-dire avec un suscepteur dont la paroi ne comporte pas d'évidements, et dans un four conforme à l'invention, à savoir un four comprenant un suscepteur dont la virole inférieure comporte trois évidements comme décrit ci-dessus. Les deux fours présentent des dimensions similaires et un chargement identique, à savoir des préformes disposées en piles verticales annulaires telles que décrites précédemment en relation avec les figures 1 et 2. L'infiltration CVI a été réalisée dans chacun des fours dans des conditions identiques (mêmes conditions de pression, de débit et de composition de gaz, et même alimentation inducteur (amplitude/fréquence)).

| Cycle CVI | Four avec virole suscepteur sans évidements | | | Four avec virole suscepteur évidé | | |
|---|---|---|---|---|---|---|
| | Début | Milieu | Fin | Début | Milieu | Fin |
| T° suscepteur (°C) | 1088 | 1084 | 1085 | 1056 | 1042 | 1033 |
| T° charge, pile latérale (°C) | 951 | 972 | 998 | 1000 | 1009 | 1010 |
| T° centre bas de pile (°C) | 927 | 948 | 977 | 945 | 960 | 978 |

Les deux processus de densification sont comparables puisque, en centre bas de pile, la température finale est pratiquement la même (977°C et 978°C).

Les relevés de température présentés dans le tableau ci-dessus montrent que dans un four utilisant un suscepteur comportant des évidements conformément à l'invention, on obtient, avec une température de suscepteur plus basse que dans un four de l'art antérieur, une température globalement plus élevée et plus homogène dans les zones de préchauffage et de chargement tout au long du cycle d'infiltration.

Les deux cycles sont tout à fait comparables puisqu'en fin de densification la température atteinte en centre bas de pile est sensiblement la même (977°C et 978°C).

La variation de température entre le début et la fin de la densification est sensiblement inférieure dans le cas de l'invention, à savoir une variation de 33°C au lieu de 47°C en centre bas de pile et une variation de 10°C au lieu de 47°C pour une pile latérale.

De plus, une température trop élevée du suscepteur est évitée, la température globale étant d'environ 1400°C. Ainsi, le risque de modification de la nature du carbone pyrolytique déposé est réduit, de même que le risque de production de dépôts indésirables (suies), et la charge thermique sur le suscepteur est réduite, lui conférant une plus longue durée de vie.

Le rendement thermique global du four est ainsi amélioré et cela ressort même de la température en centre bas de pile en début de densification qui est de 943°C au lieu de 927°C.

Selon une variante de réalisation de l'invention illustrée sur la figure 5, le suscepteur peut comprendre une virole inférieure 221 avec des évidements 2210 ménagés dans la périphérie interne de la virole.

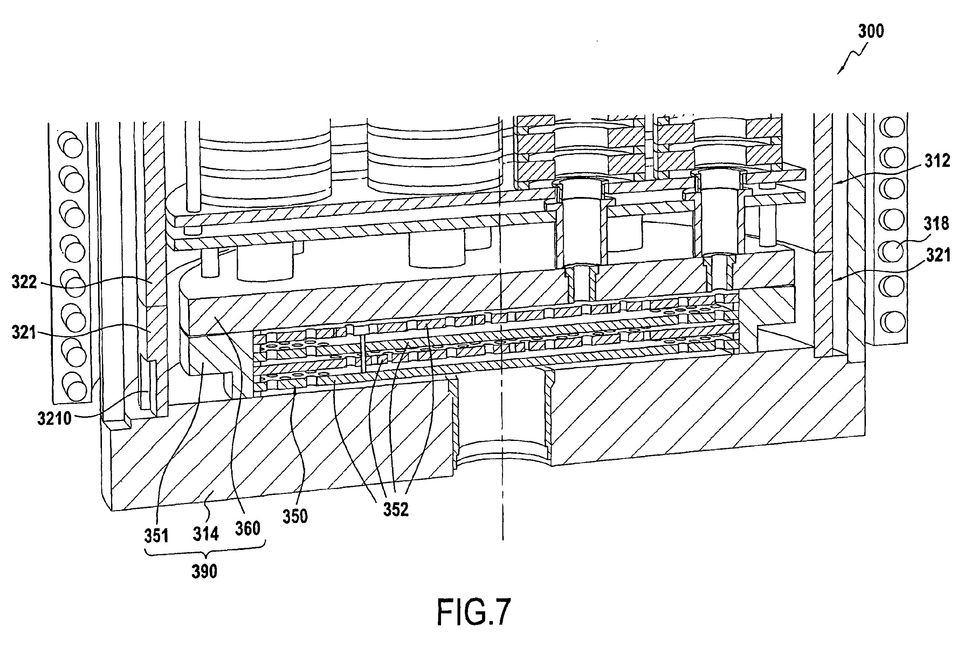

La figure 7 montre une autre variante de réalisation de four de densification 300 qui se distingue de celle de la figure 1 en ce que la virole inférieure 321 est découplée mécaniquement de la chambre de préchauffage 350. Dans ce mode de réalisation, la chambre de préchauffage 350 est formée par un boîtier 390 délimité par une paroi latérale 351, la paroi de fond 314 du four et le plateau de distribution de gaz 360. Les plateaux perforés 352 sont logés dans le boîtier ainsi formé.

La paroi latérale cylindrique 312 constituant le suscepteur du four 300 couplé avec un inducteur 318, est formée au moins en deux parties, une virole supérieure 322 dont la paroi présente une épaisseur uniforme et une virole inférieure 321. Tel qu'illustrée sur la figure 8, la virole inférieure 321 comprend comme la virole inférieure 121 décrite précédemment trois évidements 3210 répartis uniformément sur la périphérie externe de la virole 321 et formant dans la virole inférieure 321 une portion de paroi qui présente une épaisseur inférieure à l'épaisseur de la paroi du reste de la virole. Les évidements peuvent être également ménagés sur la périphérie interne de la virole.

La hauteur, la profondeur et la largeur des évidements est fonctions des critères décrits plus haut. Les évidements peuvent être également ménagés sur la périphérie interne de la virole 321.

Les autres éléments du four 300 sont identiques à ceux déjà décrits précédemment en relation avec le four 10 et ne seront pas décrits ici une nouvelle fois par souci de simplification.

Selon un aspect de l'invention, les évidements peuvent être remplis avec un matériau non conducteur afin de renforcer mécaniquement la virole au niveau des évidements. Par ailleurs, le matériau de remplissage utilisé est de préférence isolant thermiquement pour éviter un rayonnement thermique vers l'extérieur de l'enceinte du four. Un tel matériau peut être, par exemple, de l'alumine.

L'effet d'échauffement localisé produit par les évidements dans la virole inférieure du suscepteur est d'autant plus efficace que la fréquence de pilotage est basse. L'inducteur est alimenté par un générateur avec une tension alternative ayant une fréquence comprise entre 50 Hz et 1000 Hz, par exemple 850 Hz.

On notera enfin que le domaine d'application de l'invention n'est en aucune manière limité à la réalisation de disques de frein en composite C/C mais s'étend aussi à la réalisation d'autres pièces en composite C/C, par exemple des divergents de tuyères de moteurs fusée, comme montré notamment dans le brevet US 5 904 957 déjà cité. Plus généralement, l'invention peut être mise en oeuvre pour la réalisation de pièces en tout type de matériau composite thermostructural, c'est-à-dire non seulement des composites C/C mais aussi des CMC. Dans ce dernier cas, la composition du gaz réactif est choisie en fonction de la nature particulière de la matrice céramique. Des précurseurs gazeux de matrices céramiques sont bien connus, par exemple le méthyltrichlorosilane (MTS) et le gaz hydrogène ($H_2$) pour former une matrice en carbure de silicium. On pourra se référer au brevet FR 2 401 888 qui décrit des procédés de formation de différentes matrices céramiques.

Dans le cas de traitements thermiques autres que ceux destinés à la densification de substrats poreux comme, par exemple la cémentation, l'homme du métier envisagera sans difficulté la mise en oeuvre de la présente invention en utilisant et en adaptant la virole 121 décrite précédemment à la taille et à la forme du four considéré.

## Revendications

1. Four de traitement thermique (10), comprenant une zone de chargement ou de traitement (30), au moins une entrée de gaz (22), une chambre de préchauffage de gaz (50) située dans le four entre l'entrée du gaz (22) et la zone de chargement ou de traitement (30), un suscepteur comprenant au moins une paroi latérale (12) entourant la chambre de préchauffage (50) et la zone de chargement ou de traitement (30), et un inducteur (18) apte à chauffer la paroi latérale (12) par induction,
**caractérisé en ce que** la partie (121) de la paroi latérale (12) du suscepteur située autour la chambre de préchauffage (50) présente au moins deux évidements (1210) espacés circonférentiellement les uns des autres de manière à former des portions d'épaisseur réduite sur ladite partie de paroi latérale.

2. Four selon la revendication 1, **caractérisé en ce que** la paroi latérale du suscepteur située autour la chambre de préchauffage (50) présente trois évidements (1210) espacés uniformément les uns des autres.

3. Four selon la revendication 1 ou 2, **caractérisé en ce que** les évidements (1210; 2210; 3210) sont ménagés sur la périphérie interne ou sur la périphérie externe de la paroi latérale du suscepteur.

**4.** Four selon la revendication 1 ou 2, **caractérisé en ce que** les évidements (1210; 2210; 3210) sont régulièrement espacés les uns des autres.

**5.** Four selon l'une quelconque des revendications 1 à 4, **caractérisé en ce que** les portions de la paroi latérale comportant les évidements (1210; 2210; 3210) présentent une épaisseur comprise entre 30% et 60% de l'épaisseur de la paroi latérale.

**6.** Four selon l'une quelconque des revendications 1 à 5, **caractérisé en ce que** la hauteur des évidements (1210; 2210; 3210) est inférieure à celle de la chambre de préchauffage.

**7.** Four selon l'une quelconque des revendications 1 à 6, **caractérisé en ce que** les évidements (1210; 2210; 3210) présentent une largeur d'au moins 15 cm.

**8.** Four selon l'une quelconque des revendications 1 à 7, **caractérisé en ce que** la paroi latérale du suscepteur est formée d'au moins une virole supérieure (122; 322) entourant la zone de chargement (30; 330) et une virole inférieure (121; 321) entourant la chambre de préchauffage (50; 350), la virole inférieure comprenant lesdits évidements (1210; 3210).

**9.** Four selon la revendication 8, **caractérisé en ce que** la virole inférieure (121) forme la paroi latérale de la chambre de préchauffage (50) et **en ce que** ladite virole inférieure comporte un épaulement (121a) pour supporter le plateau supérieur (60) de la chambre de préchauffage (50).

**10.** Four selon l'une quelconque des revendications 1 à 9, **caractérisé en ce que** la paroi latérale (12; 312) du suscepteur est en graphite.

**11.** Four selon l'une quelconque des revendications 1 à 10, **caractérisé en ce que** les évidements sont remplis avec un matériau électriquement isolant.

**12.** Four selon la revendication 11, **caractérisé en ce que** le matériau est en outre thermiquement isolant.

**13.** Four selon l'une quelconque des revendications 1 à 12, **caractérisé en ce que** l'inducteur est relié à un générateur de tension alternative ayant une fréquence comprise entre 50 Hz et 1000 Hz.

**Claims**

**1.** A heat treatment oven (10) comprising a loading or treatment zone (30), at least one gas inlet (22), a gas preheater chamber (50) situated in the oven between the gas inlet (22) and the loading or treatment zone (30), a susceptor comprising at least a side wall (12) surrounding the preheater chamber (50) and the loading or treatment zone (30), and a field winding (18) suitable for heating the side wall (12) by induction, **characterized in that** the portion (121) of the side wall (12) of the susceptor that is situated around the preheater chamber (50) presents at least two recesses (1210) spaced apart circumferentially from one another so as to form portions of reduced thickness in said portion of the side wall.

**2.** An oven according to claim 1, **characterized in that** the side wall of the susceptor situated around the preheater chamber (50) presents three recesses (1210) spaced apart uniformly from one another.

**3.** An oven according to claim 1 or 2, **characterized in that** the recesses (1210; 2210; 3210) are formed in the inner or outer periphery of the side wall of the susceptor.

**4.** An oven according to claim 1 or 2, **characterized in that** the recesses (1210; 2210; 3210) are regularly spaced apart from one another.

**5.** An oven according to anyone of claims 1 to 4, **characterized in that** the portions of the side wall including the recesses (1210; 2210; 3210) present thickness lying in the range 30% to 60% of the thickness of the side wall.

**6.** An oven according to anyone of claims 1 to 5, **characterized in that** the height of the recesses (1210; 2210; 3210) is less than the height of the preheater chamber.

7. An oven according to anyone of claims 1 to 6, **characterized in that** the recesses (1210; 2210; 3210) present a width of at least 15 cm.

8. An oven according to anyone of claims 1 to 7, **characterized in that** the side wall of the susceptor is made up of at least of a top bushing (122; 322) surrounding the loading zone (30; 330), and a bottom bushing (121; 321) surrounding the preheater chamber (50; 350), the bottom bushing including said recesses (1210; 3210).

9. An oven according to claim 8, **characterized in that** the bottom bushing (121) forms the side wall of the preheater chamber (50), and wherein said bottom bushing includes a shoulder (121a) for supporting the top plate (60) of the preheater chamber (50).

10. An oven according to anyone of claims 1 to 9, **characterized in that** the side wall (12; 312) of the susceptor is made of graphite.

11. An oven according to anyone of claims 1 to 10, **characterized in that** the recesses are filled with an electrically insulating material.

12. An oven according to claim 11, **characterized in that** the material is also thermally insulating.

13. An oven according to anyone of claims 1 to 12, **characterized in that** the field winding is connected to an alternating voltage generator having a frequency lying in the range 50 Hz to 1000 Hz.

**Patentansprüche**

1. Wärmebehandlungsofen (10), mit einem Beschickungs- oder Behandlungsbereich (30), wenigstens einem Gaseinlaß (22), einer Gasvorheizkammer (50), die in dem Ofen zwischen dem Gaseinlaß (22) und dem Beschickungs- oder Behandlungsbereich (30) gelegen ist, einem Suszeptor, der wenigstens eine Seitenwand (12) aufweist, welche die Vorheizkammer (50) und den Beschickungs- oder Behandlungsbereich (30) umgibt, und mit einem Induktor (18), der geeignet ist, die Seitenwand (12) durch Induktion zu beheizen,
**dadurch gekennzeichnet, daß** der um die Vorheizkammer (50) herum gelegene Teil (121) der Seitenwand (12) des Suszeptors wenigstens zwei Ausnehmungen (1210) aufweist, die in Umfangsrichtung voneinander beabstandet sind, so daß sie Abschnitte von geringerer Dicke über den genannten Teil der Seitenwand bilden.

2. Ofen nach Anspruch 1, **dadurch gekennzeichnet, daß** die um die Vorheizkammer (50) befindliche Seitenwand des Suszeptors drei gleichmäßig voneinander beabstandete Ausnehmungen (1210) aufweist.

3. Ofen nach Anspruch 1 oder 2, **dadurch gekennzeichnet, daß** die Ausnehmungen (1210; 2210; 3210) an dem Innenumfang oder an dem Außenumfang der Seitenwand des Suszeptors ausgebildet sind.

4. Ofen nach Anspruch 1 oder 2, **dadurch gekennzeichnet, daß** die Ausnehmungen (1210; 2210; 3210) gleichmäßig voneinander beabstandet sind.

5. Ofen nach einem der Ansprüche 1 bis 4, **dadurch gekennzeichnet, daß** die die Ausnehmungen (1210; 2210; 3210) umfassenden Abschnitte der Seitenwand eine Dicke aufweisen, die zwischen 30 % und 60 % der Dicke der Seitenwand beträgt.

6. Ofen nach einem der Ansprüche 1 bis 5, **dadurch gekennzeichnet, daß** die Höhe der Ausnehmungen (1210; 2210; 3210) geringer als die der Vorheizkammer ist.

7. Ofen nach einem der Ansprüche 1 bis 6, **dadurch gekennzeichnet, daß** die Ausnehmungen (1210; 2210; 3210) eine Breite von wenigstens 15 cm aufweisen.

8. Ofen nach einem der Ansprüche 1 bis 7, **dadurch gekennzeichnet, daß** die Seitenwand des Suszeptors von wenigstens einem den Beschickungsbereich (30; 330) umgebenden oberen Ring (122; 322) und einem die Vorheizkammer (50; 350) umgebenden unteren Ring (121; 321) gebildet ist, wobei der untere Ring die Ausnehmungen (1210; 3210) aufweist.

9. Ofen nach Anspruch 8, **dadurch gekennzeichnet, daß** der untere Ring (121) die Seitenwand der Vorheizkammer (50) bildet und daß der untere Ring einen Ansatz (121 a) aufweist, um die obere Platte (60) der Vorheizkammer (50) zu tragen.

10. Ofen nach einem der Ansprüche 1 bis 9, **dadurch gekennzeichnet, daß** die Seitenwand (12; 312) des Suszeptors aus Graphit besteht.

11. Ofen nach einem der Ansprüche 1 bis 10, **dadurch gekennzeichnet, daß** die Ausnehmungen mit einem elektrisch isolierenden Material gefüllt sind.

12. Ofen nach Anspruch 11, **dadurch gekennzeichnet, daß** das Material ferner wärmeisolierend ist.

13. Ofen nach einem der Ansprüche 1 bis 12, **dadurch gekennzeichnet, daß** der Induktor mit einem Wechselspannungsgenerator, der eine Frequenz zwischen 50 Hz und 1000 Hz aufweist, verbunden ist.

FIG.1

FIG.2

FIG.3

EP 2 110 458 B1

EP 2 110 458 B1

FIG.4

FIG.5

14

FIG.6

FIG.8

FIG.7

EP 2 110 458 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6572371 A1
- US 5904957 A
- EP 0063988 A
- FR 2401888